# EUROPEAN PATENT APPLICATION

(11) **EP 4 709 084 A1**
(43) Date of publication of application: **11.03.2026**
(21) Application number: 25176937.8
(22) Date of filing: 16.05.2025
(51) Int. Cl.: H10D 30/66, H10D 62/10, H10D 62/832

(54) **SEMICONDUCTOR DEVICE**

(30) Priority: 09.09.2024 KR 20240122692
(71) Applicant: Samsung Electronics Co., Ltd., Suwon-si, Gyeonggi-do 16677 (KR)
(72) Inventor: KIM, Taehun, Suwon-si (KR); KO, Mingu, Suwon-si (KR); OH, Sewoong, Suwon-si (KR); PARK, Young Hwan, Suwon-si (KR); PARK, Jeonghwan, Suwon-si (KR); WOO, Sangsu, Suwon-si (KR)
(74) Representative: Marks & Clerk LLP

(57) **Abstract**

A semiconductor device includes a first conductivity type substrate, a first conductivity type epitaxial layer on a first surface of the first conductivity type substrate, and the first conductivity type epitaxial layer including a gate trench, a gate electrode in the gate trench, a gate insulating layer between the first conductivity type epitaxial layer and the gate electrode, a source electrode above the first conductivity type epitaxial layer, a first conductivity type doping layer between the first conductivity type epitaxial layer and the source electrode, and the first conductivity type doping layer, a second conductivity type doping layer, a drain electrode on a second surface of the first conductivity type substrate, and a barrier pattern including a first portion surrounding a portion of the gate trench, and a second portion between the first conductivity type epitaxial layer and the second conductivity type doping layer.

## Description

### BACKGROUND

The present disclosure concerns semiconductor devices.

In modern society, semiconductor devices are closely related to our daily lives. The importance of electric power semiconductor devices is continually increasing, and such devices may be used in various fields. In particular, electric power semiconductor devices may be used in transportation such as electric vehicles, railways, and electric trams, in renewable energy systems such as solar power generation and wind power generation, and in mobile devices. Electric power semiconductor devices are semiconductor devices capable of handling high voltage or high current, and performing functions such as electric power conversion, and controlling power in large electric power systems or high-power electronic devices. Electric power semiconductor devices may have the ability to handle high amounts of electric power while maintaining high durability. Accordingly, electric power semiconductor devices may be capable of handling large amounts of current and/or withstand high voltages. For example, electric power semiconductor devices may be capable of handling voltages from hundreds to thousands of volts, and currents from tens to thousands of amperes. Electric power semiconductor devices may improve the efficiency of the electrical energy by reducing (and/or minimizing) a power loss. Additionally, the electric power semiconductor devices may be capable of operating stably even in high temperature environments.

According to some example embodiments, electric power semiconductor devices may be classified according to substrate materials. For example, SiC (silicon carbide) electric power semiconductor devices, and GaN (gallium nitride) electric power semiconductor devices. By manufacturing the electric power semiconductor devices using substrate materials such as SiC or GaN instead of traditional substrate materials such as silicon (Si), drawbacks of silicon may be reduced, such as Si having unstable characteristics at high temperatures. SiC electric power semiconductor devices are resistant to high temperatures and have lower power loss, thereby having more suitable characteristics for electric vehicles and renewable energy systems. GaN electric power semiconductor devices may require higher costs, but may also be more efficient in terms of a speed and/or may have more suitable characteristic for high-speed charging of mobile devices.

### SUMMARY

Some example embodiments are intended to provide semiconductor devices with improved reliability and/or integration.

A semiconductor device includes a first conductivity type substrate, a first conductivity type epitaxial layer on a first surface of the first conductivity type substrate, and the first conductivity type epitaxial layer including a gate trench, a gate electrode in the gate trench, a gate insulating layer between the first conductivity type epitaxial layer and the gate electrode, a source electrode above the first conductivity type epitaxial layer, a first conductivity type doping layer between the first conductivity type epitaxial layer and the source electrode, and the first conductivity type doping layer having a first conductivity type, a second conductivity type doping layer having a second conductivity type, the second conductivity type different from the first conductivity type, a drain electrode on a second surface of the first conductivity type substrate, and a barrier pattern including a first portion surrounding at least a portion of the gate trench, and a second portion between the first conductivity type epitaxial layer and the second conductivity type doping layer.

A semiconductor device according to some example embodiments include a first conductivity type substrate, a first conductivity type epitaxial layer on a first surface of the first conductivity type substrate, and the first conductivity type epitaxial layer including a gate trench, the gate trench including a plurality of first extensions extending in a first direction, a plurality of second extensions extending in a second direction, the second direction intersecting the first direction, and a plurality of crossing regions where the plurality of first extensions and the plurality of second extensions intersect each other, a gate electrode in the gate trench, a gate insulating layer between the first conductivity type epitaxial layer and the gate electrode, a source electrode above the first conductivity type epitaxial layer, a first conductivity type doping layer between the first conductivity type epitaxial layer and the source electrode, and the first conductivity type doping layer having a first conductivity type, a second conductivity type doping layer having a second conductivity type, the second conductivity type being different from the first conductivity type, a drain electrode on a second surface of the first conductivity type substrate, and a barrier pattern overlapping the plurality of crossing regions and the second conductivity type doping layer. The barrier pattern includes a plurality of barrier patterns, and each of the plurality of barrier patterns is spaced apart from each other in the first direction and the second direction.

A semiconductor device according to some example embodiments include a first conductivity type substrate, a first conductivity type epitaxial layer on a first surface of the first conductivity type substrate, and the first conductivity type epitaxial layer including a gate trench, the gate trench including a plurality of first extensions extending in a first direction, a plurality of second extensions extending in a second direction, the second direction intersecting the first direction, and a plurality of crossing regions where the plurality of first extensions and the plurality of second extensions intersect each other, a gate electrode in the gate trench, a gate insulating layer between the first conductivity type epitaxial layer and the gate electrode, a source electrode above the first conductivity type epitaxial layer, a first conductivity type doping layer between the first conductivity type epitaxial layer and the source electrode, and the first conductivity type doping layer including a first conductivity type, a second conductivity type doping layer is at a corner of the first conductivity type doping layer, surrounded by the first conductivity type doping layer, and having a second conductivity type, the second conductivity type being different from the first conductivity type, a drain electrode on a second surface of the first conductivity type substrate, and a barrier pattern below each of the plurality of crossing regions, and the barrier pattern having the second conductivity type. The barrier pattern includes a first portion surrounding at least a portion of the plurality of crossing regions, and a second portion between the first conductivity type epitaxial layer and the second conductivity type doping layer.

According to some example embodiments, the reliability of the semiconductor devices may be improved and/or the integration of the semiconductor devices may be enhanced.

At least some of the above and other features of the invention are set out in the claims.

### BRIEF DESCRIPTION OF THE DRAWINGS

FIG. 1 and FIG. 2 are top plan views showing a semiconductor device according to some example embodiments.
FIG. 3 is a magnified top plan view of a region S1 of FIG. 1.
FIG. 4 is a cross-sectional view taken along a line A-A' of FIG. 1.
FIG. 5 is a cross-sectional view taken along a line B-B' of FIG. 1.
FIG. 6 is a cross-sectional view taken along a line C-C' of FIG. 1.
FIG. 7 is a cross-sectional view taken along a line D-D' of FIG. 1.
FIG. 8 to FIG. 11 are cross-sectional views corresponding to a line B-B' of FIG. 1 showing semiconductor devices according to some example embodiments.
FIG. 12 is a top plan view showing a semiconductor device according to some example embodiments.
FIG. 13 is a cross-sectional view taken along a line E-E' of FIG. 12.
FIG. 14 and FIG. 15 are cross-sectional views corresponding to a line E-E' of FIG. 12, illustrating semiconductor devices according to some example embodiments.
FIG. 16 and FIG. 17 are top plan views illustrating semiconductor devices according to some example embodiments.
FIG. 18 is a top plan view corresponding to a region S1 of FIG. 1, showing a semiconductor device according to some example embodiments.
FIG. 19 is a cross-sectional view taken along a line F-F' of FIG. 18.
FIG. 20 is a top plan view corresponding to a region S1 of FIG. 1, showing a semiconductor device according to some example embodiments.
FIG. 21 is a cross-sectional view taken along a line F-F' of FIG. 20.

### DETAILED DESCRIPTION

Some example embodiments of the present disclosure will be described more fully hereinafter with reference to the accompanying drawings, in which some example embodiments of the disclosure are shown. As those skilled in the art would realize, the described example embodiments may be modified in various different ways, all without departing from the scope of the present disclosure.

Descriptions of parts not related to the present disclosure are omitted, and like reference numerals designate like elements throughout the specification.

Further, since sizes and thicknesses of constituent members shown in the accompanying drawings are arbitrarily given for better understanding and ease of description, the present disclosure is not limited to the illustrated sizes and thicknesses. In the drawings, the thickness of layers, films, panels, regions, etc., are exaggerated for clarity. In the drawings, for better understanding and ease of description, the thicknesses of some layers and areas are exaggerated.

It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, in the specification, the word "on" or "above" means positioned on or below the object portion, and does not necessarily mean positioned on the upper side of the object portion based on a gravitational direction.

In addition, unless explicitly described to the contrary, the word "comprise," and variations such as "comprises" or "comprising," will be understood to imply the inclusion of stated elements but not the exclusion of any other elements.

Further, throughout the specification, the phrase "in a plan view" means viewing a target portion from the top, and the phrase "in a cross-sectional view" means viewing a cross-section formed by vertically cutting a target portion from the side.

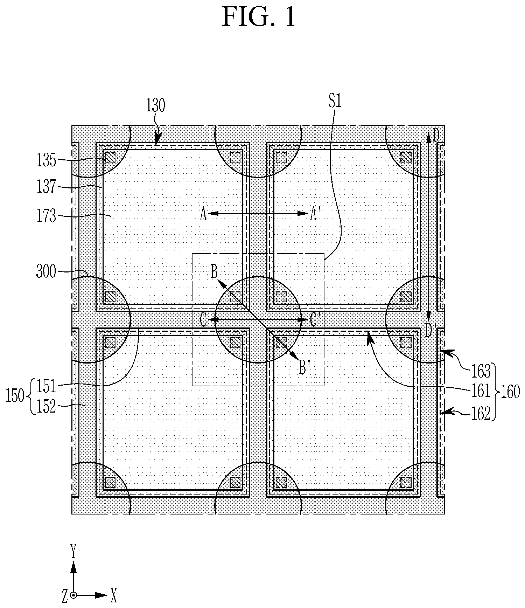

Hereinafter, a semiconductor device according to some example embodiments will be described with reference to of FIG. 1 to FIG. 7.

Referring to FIG. 1 to FIG. 7, a semiconductor device according to some example embodiments includes a first conductivity type substrate 110, a first conductivity type epitaxial layer 131 positioned on the first surface of the first conductivity type substrate 110 and including a gate trench 160, a gate electrode 150 positioned within the gate trench 160, a gate insulating layer 140 placed between the first conductivity type epitaxial layer 131 and the gate electrode 150, a source electrode 173 disposed on the first conductivity type epitaxial layer 131, a first conductivity type doping layer 137 and a second conductivity type doping layer 135 disposed between the first conductivity type epitaxial layer 131 and the source electrode 173, a drain electrode 175 positioned on the second surface of the first conductivity type substrate 110, a barrier pattern 300 surrounding at least a part of the gate electrode 150 and disposed between the first conductivity type epitaxial layer 131 and the second conductivity type doping layer 135.

The first conductivity type substrate 110 may be a semiconductor substrate including SiC (silicon carbide). For example, the first conductivity type substrate 110 may be formed of a 4H SiC substrate. In some cases, the first conductivity type substrate 110 may be composed of a 3C SiC substrate, a 6H SiC substrate, etc. The first conductivity type substrate 110 may be doped with an n-type. The first conductivity type substrate 110 may be doped with the n-type of high concentration. The resistivity of the first conductivity type substrate 110 may be between about 0.005Ωcm and about 0.035Ωcm. The thickness of the first conductivity type substrate 110 may be from about 10 µm to about 700 µm. The material, doping type, doping concentration, resistivity, thickness, etc. of the first conductivity type substrate 110 are not limited to this and may be changed in various ways. The first conductivity type substrate 110 may include the first surface and the second surface facing each other. The first surface of the first conductivity type substrate 110 may be an upper surface, and the second surface of the first conductivity type substrate 110 may be a lower surface.

The first conductivity type epitaxial layer 131 may be positioned on the first surface, e.g., the upper surface, of the first conductivity type substrate 110. The lower surface of the first conductivity type epitaxial layer 131 may be in contact with the upper surface of the first conductivity type substrate 110. However, the present disclosure is not limited thereto, and a desired (and/or alternatively predetermined) other layer may be positioned between the first conductivity type substrate 110 and the first conductivity type epitaxial layer 131. The first conductivity type epitaxial layer 131 may be an epitaxy layer formed from the first conductivity type substrate 110 by using an epitaxial growth method. The first conductivity type epitaxial layer 131 may include SiC. For example, the first conductivity type epitaxial layer 131 may include 4H SiC. The first conductivity type epitaxial layer 131 may be doped with an n-type. The first conductivity type epitaxial layer 131 may be n-type with a low concentration doping. The doping concentration of the first conductivity type epitaxial layer 131 may be lower than the doping concentration of the first conductivity type substrate 110. The doping concentration of the first conductivity type epitaxial layer 131 may be about 1*10¹⁵cm⁻³ or more and about 1*10¹⁷cm⁻³ or less. The thickness of the first conductivity type epitaxial layer 131 may be about 1 µm or more and about 13 µm or less. The material, doping type, doping concentration, thickness, etc. of the first conductivity type epitaxial layer 131 are not limited to the example embodiments and may be changed in various ways. For example, the first conductivity type may be p-type.

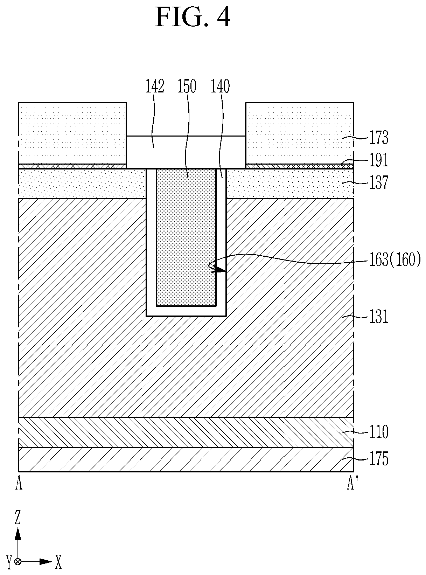

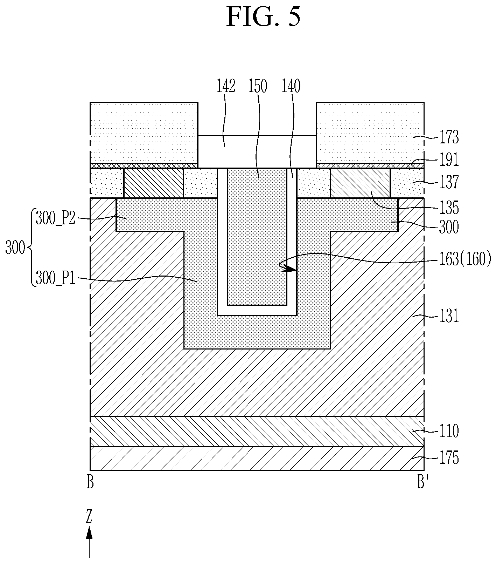

The first conductivity type epitaxial layer 131 may include the gate trench 160. The gate trench 160 may be formed to have a desired (and/or alternatively predetermined) depth on the upper surface of the first conductivity type epitaxial layer 131. As shown in FIG. 4 and FIG. 5, the gate trench 160 may be formed in an approximately U-shape in a cross-section. The gate trench 160 may include a bottom surface and a sidewall extending from the bottom surface. In FIG. 4 and FIG. 5, the angle of the sidewall with respect to the bottom surface of the gate trench 160 is depicted to be vertical, but example embodiments are not limited thereto.

The gate trench 160 may have a lattice pattern on a plane consisting of a first direction (a X direction) and a second direction (a Y direction). For example, the gate trench 160 may include a plurality of first extensions 161 extending in the first direction (the X direction), a plurality of second extensions 162 extending in the second direction (the Y direction), and a plurality of crossing regions 163 where the plurality of first extensions 161 and the plurality of second extensions 162 intersect each other. The plurality of first extensions 161 may be extended in the first direction (the X direction) and arranged spaced apart from each other along the second direction (the Y direction). The plurality of first extensions 161 may be extended in the direction parallel to each other. The plurality of second extensions 162 may be extended in the second direction (the Y direction) and arranged spaced apart from each other along the first direction (the X direction). The plurality of second extensions 162 can extend in the direction parallel to each other. The plurality of first extensions 161 and the plurality of first extensions 161 may intersect each other in the plurality of crossing regions 163. Accordingly, the plurality of crossing regions 163 may be arranged spaced apart from each other along the first direction (the X direction) and the second direction (the Y direction). In some example embodiments, the plurality of crossing regions 163 may refer to a portion of the gate trench 160 that overlaps the barrier pattern 300, which will be described later, in a third direction (a Z direction). Here, the second direction (the Y direction) may mean a direction that intersects the first direction (the X direction). For example, the second direction (the Y direction) may be a direction orthogonal to the first direction (the X direction).

In some example embodiments, each of the plurality of first extensions 161, the plurality of second extensions 162, and the plurality of crossing regions 163 may include a bottom surface and a sidewall extending from the bottom surface. The bottom surface and sidewall of the plurality of first extensions 161 may be defined by the first conductivity type epitaxial layer 131. The bottom surface and sidewall of the plurality of second extensions 162 may be defined by the first conductivity type epitaxial layer 131. The bottom and sidewalls of the plurality of crossing regions 163 may be defined by the barrier pattern 300, which will be described later.

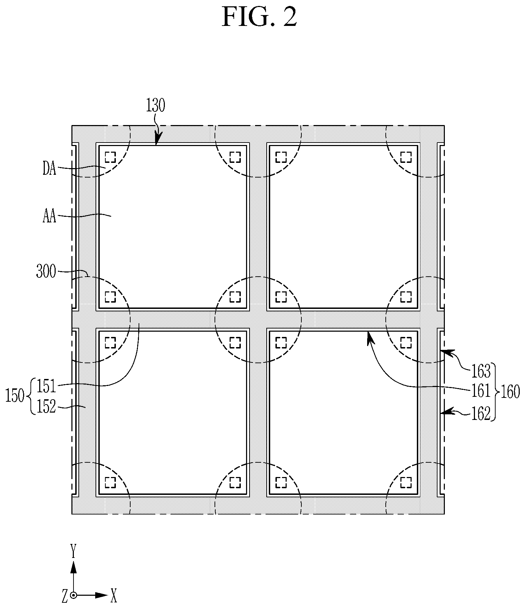

In some example embodiments, a plurality of unit cell regions 130 may be defined by the gate trench 160. For example, as illustrated in FIG. 2, the semiconductor device according to some example embodiments may include the plurality of unit cell regions 130 defined by the gate trench 160. The plurality of unit cell regions 130 may be arranged spaced apart along the first direction (the X direction) and the second direction (the Y direction). the plurality of unit cell regions 130 may be separated from each other by the gate trench 160. That is, the gate trench 160 may be positioned between the plurality of unit cell regions 130 adjacent in the first direction (the X direction) and between the plurality of unit cell regions 130 adjacent in the second direction (the Y direction). The plurality of unit cell regions 130 may have a quadrangle shape on a plane formed by the first direction (the X direction) and the second direction (the Y direction), but example embodiments are not limited thereto.

Each of the plurality of unit cell regions 130 of the semiconductor device according to some example embodiments may include a dummy area DA and an active area AA. The dummy area DA may be positioned at each corner of the plurality of unit cell regions 130. For example, the dummy area DA may be positioned adjacent to the plurality of crossing regions 163 of the gate trench 160, and positioned at the corner of each of the plurality of unit cell regions 130. The dummy area DA may mean a region where the barrier pattern 300, which will be explained later, is positioned. The dummy area DA may mean an area that alleviates an electric field generated by a portion of the gate electrode 150 positioned within the plurality of crossing regions 163 when a turn-on signal is applied to the gate electrode 150.

In some example embodiments, each area of the plurality of unit cell regions 130, excluding the dummy area DA, may be the active area AA. The active area AA may mean an area where the barrier pattern 300, which will be explained later, is not positioned. The active area AA may be an area that functions as a transistor. For example, the active area AA may mean an area where a current path is formed from the source electrode 173 to the drain electrode 175 by the gate electrode 150, which will be described later. For example, the active area AA of the semiconductor device according to some example embodiments may include an n-type field effect transistor (n-FET, n type Field Effect Transistor). However, but example embodiments are not limited thereto, the active area AA may also include a p-type field effect transistor.

The gate electrode 150 may be positioned within the gate trench 160 of the first conductivity type epitaxial layer 131. The gate electrode 150 may be separated from the first conductivity type epitaxial layer 131. The gate electrode 150 may be spaced apart from the first conductivity type epitaxial layer 131 at a substantially constant interval. However, example embodiments are not limited thereto, and the separation distance between the gate electrode 150 and the first conductivity type epitaxial layer 131 may vary depending on the position. The gate electrode 150 may have a cross-section shape similar to the gate trench 160. The gate electrode 150 may include a bottom surface and a side surfaces extending from the bottom surface, and the bottom surface and the side surfaces of the gate electrode 150 may be formed in an approximately U-shape in a cross-section following the shape of the gate trench 160. The gate electrode 150 may further include an upper surface facing the bottom surface, and the side surface may connect between the bottom surface and the upper surface. The bottom surface of the gate electrode 150 may face the bottom surface of the gate trench 160. The side surfaces of the gate electrode 150 may face the sidewalls of the gate trench 160.

The gate electrode 150 may have a lattice pattern on a plane. For example, the gate electrode 150 may include a plurality of first extending patterns 151 positioned within the plurality of first extensions 161 of the gate trench 160, and a plurality of second extending patterns 152 positioned within the plurality of second extensions 162 of the gate trench 160. The plurality of first extending patterns 151 may be extended in the first direction (the X direction) and arranged spaced apart from each other along the second direction (the Y direction). The plurality of first extending patterns 151 may extend in a direction parallel to each other. The plurality of second extending patterns 152 may be extended in the second direction (the Y direction) and arranged spaced apart from each other along the first direction (the X direction). The plurality of second extending patterns 152 may extend in a direction. Parallel to each other. The plurality of first extending patterns 151 and the plurality of first extending patterns 151 may intersect each other in the plurality of crossing regions 163 of the gate trench 160.

In some example embodiments, the gate electrode 150 may have a desired (and/or alternatively predetermined) width. For example, the width of the plurality of first extending patterns 151 of the gate electrode 150 along the second direction (the Y direction) and the width of the plurality of second extending patterns 152 along the first direction (the X direction) may be from about 0.1 µm to about 0.3 µm. This is the reason that the barrier pattern 300 of the semiconductor device according to some example embodiments may be positioned under the plurality of crossing regions 163 of the gate trench 160, not positioned under at least a portion of the plurality of first extensions 161 and at least a portion of the plurality of second extensions 162, For example, there may be a gap between adjacent barrier regions 300 overlapping adjacent crossing regions 163. consequently, the process of forming the barrier pattern 300 under the plurality of first extensions 161 and the plurality of second extensions 162 may be omitted, thereby the width of the gate electrode 150 may be designed relatively smaller compared to the case where the barrier pattern 300 is positioned under the plurality of first extensions 161 and the plurality of second extensions 162. Accordingly, the distance between adjacent plurality of unit cell regions 130 may be reduced, thereby improving the integrity of the semiconductor device according to some example embodiments.

The gate electrode 150 may include a conductive material. For example, the gate electrode 150 may include an impurity doped polysilicon. As another example, the gate electrode 150 can include a metal, a metal alloy, a conductive metal nitride, a metal silicide, a doped semiconductor material, a conductive metal oxide, a conductive metal nitride, or a combination thereof. However, example embodiments are not limited thereto. The gate electrode 150 may be composed of a single layer or multiple layers.

The gate insulating layer 140 is positioned between the first conductivity type epitaxial layer 131 and the gate electrode 150. That is, the gate insulating layer 140 may be positioned below the gate electrode 150 and cover the bottom surface of the gate electrode 150. The gate electrode 150 may be insulated from the first conductivity type epitaxial layer 131 by the gate insulating layer 140. The gate electrode 150 may be surrounded by the gate insulating layer 140.

The gate insulating layer 140 may be positioned on the bottom surface and sidewall of the gate trench 160. For example, the gate insulating layer 140 may be positioned with a uniform or substantially uniform thickness over the bottom surface and the sidewall of the plurality of first extensions 161, the plurality of second extensions 162, and the plurality of crossing regions 163. Therefore, the distance between the gate electrode 150 and the first conductivity type epitaxial layer 131 may be almost constant.

The gate insulating layer 140 may include an insulating material. For example, the gate insulating layer 140 may include SiO₂. However, example embodiments are not limited to thereto, and the material of the gate insulating layer 140 may be changed in various ways. As another example, the gate insulating layer 140 may include SiN, SiON, SiC, SiCN or a combination thereof. The gate insulating layer 140 may be composed of a single layer or multiple layers.

The semiconductor device according to some example embodiments may further include a capping layer 142 positioned over the gate electrode 150. The capping layer 142 may cover the upper surface of the gate electrode 150. Additionally, the capping layer 142 may cover at least a portion of the gate insulating layer 140 and the first conductivity type doping layer 137 adjacent to the gate electrode 150. The capping layer 142 may be positioned between the source electrodes 173, which will be described later. For example, the capping layer 142 may be positioned between the source electrodes 173 adjacent in the first direction (the X direction) and between the source electrodes 173 adjacent in the second direction (the Y direction). The gate electrode 150 may be insulated from the source electrode 173 by the capping layer 142.

The thickness of the capping layer 142 along the third direction (the Z direction) may be almost constant. However, example embodiments are not limited thereto, the thickness of the capping layer 142 along the third direction (the Z direction) may gradually decrease from the center of the capping layer 142 to opposite edges. The thickness of the capping layer 142 may be different from the thickness of the gate insulating layer 140. For example, the thickness of the capping layer 142 may be thicker than the thickness of the gate insulating layer 140. In some cases, the thickness of the capping layer 142 may be similar to the thickness of the gate insulating layer 140.

The capping layer 142 may include an insulating material. For example, the capping layer 142 may include SiO₂, SiOP, SiN, SiON or a combination thereof. However, it is not limited to this, and the material of the capping layer 142 may be changed in various ways. The capping layer 142 may be composed of a single layer or multiple layers. The capping layer 142 may include the same material as the gate insulating layer 140, or may include a different material. When the capping layer 142 is made of the same material as the gate insulating layer 140, the boundary between the capping layer 142 and the gate insulating layer 140 may not be clearly distinguished at the part where the capping layer 142 and the gate insulating layer 140 come into contact.

The source electrode 173 may be positioned on the first conductivity type epitaxial layer 131. The source electrode 173 may be positioned on the upper surface of the first conductivity type doping layer 137 and the upper surface of the second conductivity type doping layer 135, which will be described later.

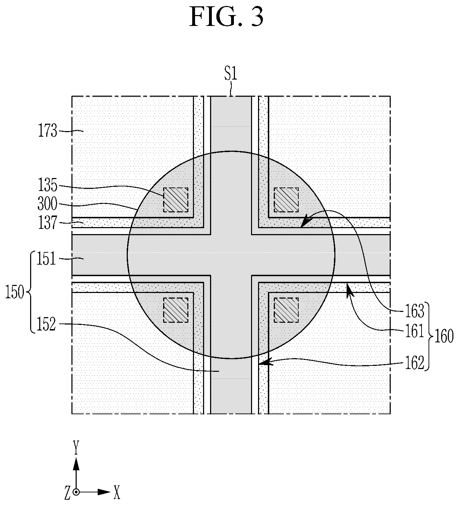

The source electrode 173 may be positioned apart from the gate trench 160. For example, as shown in FIG. 1 and FIG. 3, on a plane formed by the first direction (the X direction) and the second direction (the Y direction), the source electrode 173 may be positioned spaced apart from the plurality of first extensions 161 along the second direction (the Y direction), and may be positioned spaced apart from the plurality of second extensions 162 along the first direction (the X direction). The source electrode 173 may be positioned apart from the plurality of crossing regions 163 along the first direction (the X direction) and the second direction (the Y direction). That is, the source electrode 173 may overlap the gate trench 160 and the gate electrode 150 in the third direction (the Z direction). Additionally, the source electrode 173 may be positioned apart from the gate electrode 150 along the third direction (the Z direction), but example embodiments are not limited thereto.

The source electrode 173 may include a conductive material. For example, the source electrode 173 may include a metal, a metal alloy, a conductive metal nitride, a metal silicide, a doped semiconductor material, a conductive metal oxide, or a conductive metal oxynitride. For example, the source electrode 173 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAlN), tungsten nitride (WN), ruthenium (Ru), titanium aluminum (TiAl), titanium aluminum carbonization nitride (TiAIC-N), titanium aluminum carbide (TiAIC), titanium carbide (TiC), tantalum carbonization nitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof. However, example embodiments are not limited thereto. The source electrode 173 may be composed of a single layer or multiple layers.

The semiconductor device according to some example embodiments may further include a metal silicide layer 191 positioned between the source electrode 173 and the first conductivity type epitaxial layer 131. For example, the metal silicide layer 191 may be positioned between the first conductivity type doping layer 137 and the source electrode 173 and between the second conductivity type doping layer 135 and the source electrode 173. The first conductivity type doping layer 137 and the source electrode 173 may be electrically connected smoothly by the metal silicide layer 191.

The first conductivity type doping layer 137 may be positioned on the first conductivity type epitaxial layer 131. The first conductivity type doping layer 137 is positioned between the first conductivity type epitaxial layer 131 and the source electrode 173. One surface of the first conductivity type doping layer 137 may be in contact with the first conductivity type epitaxial layer 131, and the other surface of the first conductivity type doping layer 137 may be in contact with the metal silicide layer 191 (or the source electrode 173).

In some example embodiments, at least a portion of the first conductivity type doping layer 137 may be positioned on the barrier pattern 300, which will be described later. For example, the barrier pattern 300 may be positioned adjacent to the plurality of crossing regions 163 of the gate trench 160, and the first conductivity type doping layer 137 may be positioned on the barrier pattern 300. A part of the bottom surface of the first conductivity type doping layer 137 may be in contact with the barrier pattern 300, but example embodiments are not limited thereto. The detailed description thereof will be given later in the description of the barrier pattern 300.

The first conductivity type doping layer 137 may be separated from each other by the gate trench 160. For example, the first conductivity type doping layer 137 may be separated from each other in the second direction (the Y direction) by the plurality of first extensions 161 of the gate trench 160. The first conductivity type doping layer 137 may be separated from each other in the first direction (the X direction) by the plurality of second extensions 162 of the gate trench 160. That is, the first conductivity type doping layer 137 may be positioned apart from each other along the first direction (the X direction) and the second direction (the Y direction) by the gate trench 160. The first conductivity type doping layer 137 may be arranged along the first direction (the X direction) and the second direction (the Y direction).

Accordingly, the first conductivity type doping layer 137 may be positioned on opposite sides of the gate trench 160. For example, as shown in FIG. 4 and FIG. 5, the first conductivity type doping layer 137 may be positioned on opposite sides of the gate trench 160 along the first direction (the X direction) and the second direction (the Y direction). The first conductivity type doping layer 137 may overlap the gate trench 160 in the third direction (the Z direction). The first conductivity type doping layer 137 may not cover the gate trench 160. In some example embodiments, the first conductivity type doping layer 137 may have an approximately rectangular shape on a plane, but example embodiments are not limited thereto.

The first conductivity type doping layer 137 may face the gate electrode 150 with the gate insulating layer 140 interposed therebetween. The surface of the first conductivity type doping layer 137 facing the gate electrode 150 may be positioned on the same boundary line as the sidewall of the gate trench 160. The upper surface of the first conductivity type doping layer 137 may be in contact with the metal silicide layer 191, and the bottom surface of the first conductivity type doping layer 137 may be in contact with the first conductivity type epitaxial layer 131. The source electrode 173 and the metal silicide layer 191 may be in ohmic contact with the first conductivity type doping layer 137. The region in contact with the metal silicide layer 191 within the first conductivity type doping layer 137 may be doped at a relatively high concentration compared to other regions. However, example embodiments are not limited thereto, and another desired (and/or alternatively predetermined) layer may be positioned between the first conductivity type doping layer 137 and the source electrode 173. At least a portion of the upper surface of the first conductivity type doping layer 137 may be covered by the capping layer 142, but example embodiments are not limited thereto.

The first conductivity type doping layer 137 may be a doping region formed by using an ion implantation process in the first conductivity type epitaxial layer 131. The first conductivity type doping layer 137 may include SiC. For example, the first conductivity type doping layer 137 may include 4H SiC. The first conductivity type doping layer 137 may be n-type doped. The first conductivity type doping layer 137 may be high concentration doped with the n-type. The doping concentration of the first conductivity type doping layer 137 may be about 1*10¹⁸cm⁻³ or more to about 5*10²⁰cm⁻³ or less. The thickness of the first conductivity type doping layer 137 may be about 0.1 µm or more to about 0.5 µm or less. The material, doping type, doping concentration, etc. of the first conductivity type doping layer 137 are not limited thereto and may be changed in various ways.

The second conductivity type doping layer 135 may be positioned on the first conductivity type epitaxial layer 131. The second conductivity type doping layer 135 may be positioned between the first conductivity type epitaxial layer 131 and the source electrode 173. The bottom surface of the second conductivity type doping layer 135 may be in contact with the first conductivity type epitaxial layer 131, and the upper surface of the second conductivity type doping layer 135 may be in contact with the metal silicide layer 191. Accordingly, the second conductivity type doping layer 135 may be electrically connected to the source electrode 173 through the metal silicide layer 191.

In some example embodiments, the second conductivity type doping layer 135 may be positioned at the corner of the first conductivity type doping layer 137. For example, the second conductivity type doping layer 135 may be positioned at each of four corners of the first conductivity type doping layer 137 on a plane formed along the first direction (the X direction) and the second direction (the Y direction). The second conductivity type doping layer 135 may be adjacent to the plurality of crossing regions 163 of the gate trench 160.

Additionally, the second conductivity type doping layer 135 may be positioned on one side of the first conductivity type doping layer 137. For example, on a plane, the second conductivity type doping layer 135 may be surrounded by the first conductivity type doping layer 137, but example embodiments are not limited thereto. Opposite sides of the second conductivity type doping layer 135 may be in contact with the first conductivity type doping layer 137. Accordingly, the first conductivity type doping layer 137 may include a portion positioned between the gate trench 160 and the second conductivity type doping layer 135. Additionally, the first conductivity type doping layer 137 may be positioned between the second conductivity type doping layer 135 and the gate insulating layer 140. The first conductivity type doping layer 137 may be positioned between the second conductivity type doping layer 135 and the gate electrode 150. The second conductivity type doping layer 135 may be positioned apart from the gate trench 160 in the horizontal direction (the first direction (the X direction) and/or the second direction (the Y direction)).

The second conductivity type doping layer 135 may be positioned in the same layer as the first conductivity type doping layer 137. The upper surface of the second conductivity type doping layer 135 may be positioned at substantially the same level as the upper surface of the first conductivity type doping layer 137. That is, the upper surface of the second conductivity type doping layer 135 may be positioned at substantially the same distance from the upper surface of the first conductivity type doping layer 137 and the upper surface of the first conductivity type substrate 110. Additionally, the bottom surface of the second conductivity type doping layer 135 may be positioned at substantially the same level as the bottom surface of the first conductivity type doping layer 137. That is, the bottom surface of the second conductivity type doping layer 135 may be positioned at substantially the same distance from the bottom surface of the first conductivity type doping layer 137 and the upper surface of the first conductivity type substrate 110.

At least a portion of the second conductivity type doping layer 135 may be positioned on the barrier pattern 300, which will be described later. For example, the barrier pattern 300 may be positioned adjacent to the plurality of crossing regions 163 of the gate trench 160, and the second conductivity type doping layer 135 may be positioned on the barrier pattern 300. A part of the bottom surface of the second conductivity type doping layer 135 may be in contact with the barrier pattern 300, but example embodiments are not limited thereto. A detailed description thereof will be given later in the description of the barrier pattern 300.

The second conductivity type doping layer 135 may be a doping region formed using an ion implantation process in the first conductivity type epitaxial layer 131. The second conductivity type doping layer 135 may include SiC. For example, the second conductivity type doping layer 135 may include 4H SiC. The second conductivity type doping layer 135 may be p-type doped. The second conductivity type doping layer 135 may be high concentration doped with a p-type. The doping concentration of the second conductivity type doping layer 135 may be about 1*10¹³cm⁻³ or more to about 5*10²⁰cm⁻³ or less. The material, doping type, doping concentration, etc. of the second conductivity type doping layer 135 are not limited thereto and may be changed in various ways. For example, the second conductivity type may be n-type.

The drain electrode 175 may be positioned on the second surface, e.g., the bottom surface, of the first conductivity type substrate 110. The upper surface of the drain electrode 175 may be in contact with the bottom surface of the first conductivity type substrate 110. The drain electrode 175 may be in ohmic contact with the first conductivity type substrate 110. The region in contact with the drain electrode 175 within the first conductivity type substrate 110 may be doped at a relatively high concentration compared to other regions. However, example embodiments are not limited to thereto, and another desired (and/or alternatively predetermined) layer may be positioned between the drain electrode 175 and the first conductivity type substrate 110. For example, a silicide layer may be further positioned between the drain electrode 175 and the first conductivity type substrate 110. The drain electrode 175 and the first conductivity type substrate 110 may be electrically connected smoothly by the silicide layer.

The drain electrode 175 may include a conductive material. For example, the drain electrode 175 may include a metal, a metal alloy, a conductive metal nitride, a metal silicide, a doped semiconductor material, a conductive metal oxide, or a conductive metal oxynitride. However, example embodiments are not limited thereto. The drain electrode 175 may be made of the same material as the source electrode 173, or may be made of a different material. The drain electrode 175 may be formed of a single layer or multilayer.

The barrier pattern 300 may be positioned on the first conductivity type epitaxial layer 131. The barrier pattern 300 may surround at least a portion of the gate trench 160 over the first conductivity type epitaxial layer 131. The barrier pattern 300 may be positioned beneath at least a portion of the gate trench 160. For example, the barrier pattern 300 may be positioned beneath the plurality of crossing regions 163 of the gate trench 160. Additionally, the barrier pattern 300 may be positioned between the first conductivity type epitaxial layer 131 and the first conductivity type doping layer 137 and between the first conductivity type epitaxial layer 131 and the second conductivity type doping layer 135. The barrier pattern 300 may overlap the second conductivity type doping layer 135 in the third direction (the Z direction). The upper surface of the barrier pattern 300 may be in contact with the second conductivity type doping layer 135. Accordingly, the barrier pattern 300 may be electrically connected to the source electrode 173 through the second conductivity type doping layer 135.

The barrier pattern 300 may be positioned in the dummy area DA. The barrier pattern 300 may be positioned apart from each other along the first direction (the X direction) and the second direction (the Y direction). The barrier pattern 300 may be arranged along the first direction (the X direction) and the second direction (the Y direction). For example, the barrier pattern 300 may be positioned under the plurality of crossing regions 163, but may not be positioned under at least a portion of the plurality of first extensions 161 and at least a portion of the plurality of second extensions 162. That is, the barrier pattern 300 may only be positioned below the plurality of crossing regions 163. The barrier pattern 300 may only be positioned at the intersection of the plurality of first extensions 161 and the plurality of second extensions 162.

The barrier pattern 300 may overlap the plurality of crossing regions 163 in the third direction (the Z direction), and need not overlap at least a portion of the plurality of first extensions 161 and at least a portion of the plurality of second extensions 162 in the third direction (the Z direction). For example, there may be a gap between adjacent barrier regions 300 overlapping adjacent crossing regions 163. Accordingly, the barrier pattern 300 may be spaced apart from each other and arranged in a direction parallel to the plurality of first extensions 161 and the plurality of second extensions 162. The minimum distance between the adjacent barrier patterns 300 may be from about 0.1 µm to about 10 µm. The barrier pattern 300 may sufficiently secure an area of the active area AA where a current path is formed from the source electrode 173 toward the drain electrode 175 by the gate electrode 150 while alleviating the electric field generated by the portion of the gate electrode 150 positioned within the plurality of crossing regions 163.

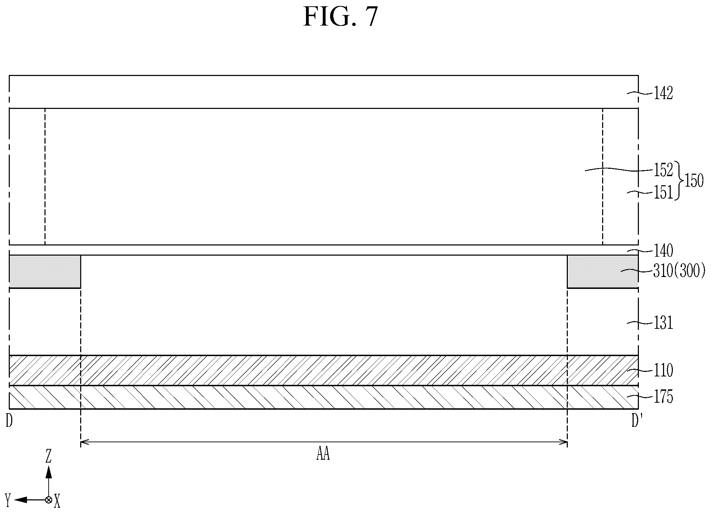

Accordingly, the barrier pattern 300 may be positioned on the bottom surface of at least a portion of the gate electrode 150. The barrier pattern 300 may be positioned spaced apart from each other on the bottom surface of the gate electrode 150. For example, as illustrated in FIG. 7, the barrier pattern 300 may be positioned spaced along the second direction (the Y direction) on the bottom surface of the plurality of second extending patterns 152 that extend in the second direction (the Y direction). At this time, the active area AA may be positioned between the barrier patterns 300 spaced apart in the second direction (the Y direction). The barrier pattern 300 need not be positioned in the active area AA.

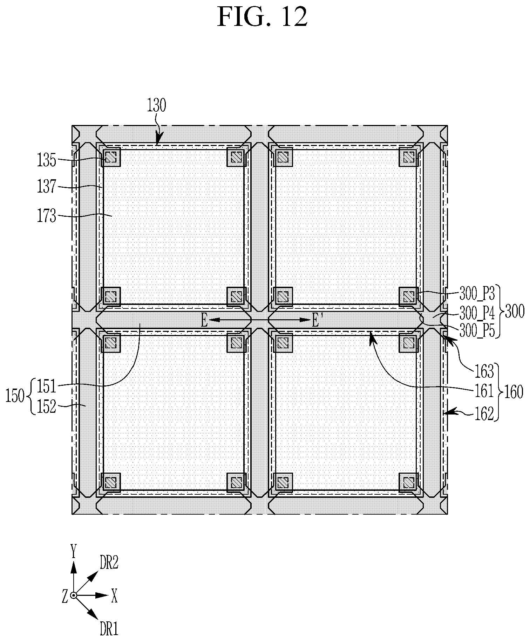

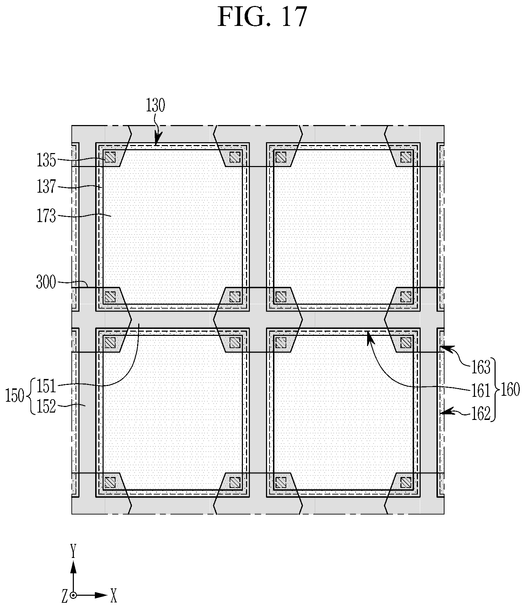

In some example embodiments, when viewed on a plane formed by the first direction (the X direction) and the second direction (the Y direction), the barrier pattern 300 may have a circular shape. However, the planar shape of the barrier pattern 300 may be changed in various ways, but example embodiments are not limited thereto. The description thereof will be given later with reference to FIG. 12 and FIG. 17.

The barrier pattern 300 may be a doping region formed using an ion implantation process within the first conductivity type epitaxial layer 131. The barrier pattern 300 may include SiC. For example, the barrier pattern 300 may include 4H SiC. The barrier pattern 300 may have the same conductivity type as the second conductivity type doping layer 135. For example, the barrier pattern 300 may be doped with a p-type. The barrier pattern 300 may be doped with a p-type. The doping concentration of the barrier pattern 300 may be less than or equal to or substantially equal to the doping concentration of the second conductivity type doping layer 135, but example embodiments are not limited thereto. The doping concentration of the barrier pattern 300 may be greater than or equal to or substantially equal to the doping concentration of the first conductivity type epitaxial layer 131, but example embodiments are not limited thereto. In some example embodiments, the barrier pattern 300 may be formed of a single layer or multiple layers.

The barrier pattern 300 of the semiconductor device according to some example embodiments may include a first portion 300_P1 surrounding at least a portion of the gate trench 160 and a second portion 300_P2 positioned between the first conductivity type epitaxial layer 131 and the second conductivity type doping layer 135.

The first portion 300_P1 may be positioned on the first conductivity type epitaxial layer 131. The first portion 300_P1 may surround at least a portion of the gate trench 160. For example, as illustrated in FIG. 5, the first portion 300_P1 may surround at least a portion of each of the plurality of crossing regions 163 of the gate trench 160. The first portion 300_P1 may be positioned below the plurality of crossing regions 163 and may surround a portion of the sidewall of the gate trench 160. The first portion 300_P1 may constitute at least a portion of the bottom surface and sidewall of the plurality of crossing regions 163. Additionally, as illustrated in FIG. 4, the first portion 300_P1 may not surround the plurality of first extensions 161 and the plurality of second extensions 162 of the gate trench 160.

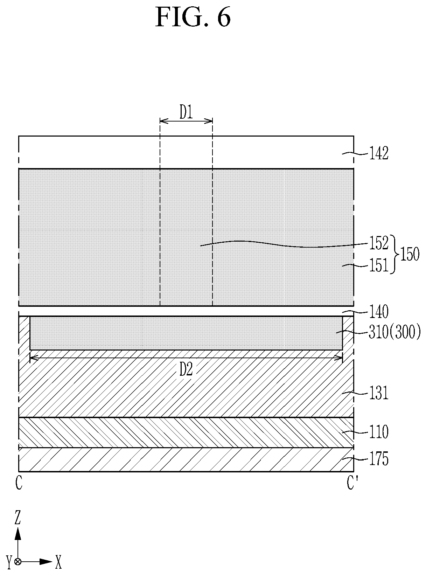

Accordingly, the first portion 300_P1 may be positioned below the gate electrode 150 positioned within the gate trench 160. The gate insulating layer 140 may be positioned between the gate electrode 150 and the first portion 300_P1. The upper surface and one side surface of the first portion 300_P1 may be in contact with the gate insulating layer 140. The first portion 300_P1 may surround at least a portion of the gate electrode 150. For example, the first portion 300_P1 may surround at least a portion of the bottom surface and sidewall of the gate electrode 150. The first portion 300_P1 may overlap at least a part of the gate electrode 150 in the horizontal direction (the first direction (the X direction) and/or the second direction (the Y direction)). Additionally, the first portion 300_P1 may overlap the gate electrode 150 in the third direction (the Z direction). For example, as illustrated in FIG. 6, the first portion 300_P1 may overlap at least a portion of the plurality of first extending patterns 151 of the gate electrode 150 and at least a portion of the plurality of second extending patterns 152 in the third direction (the Z direction).

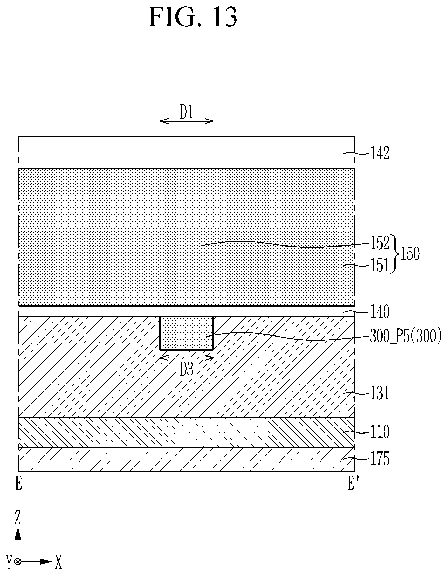

At this time, the second width D2 of the first portion 300_P1 along the first direction (the X direction) may be larger than the first width D1 of the second extending pattern 152 of the gate electrode 150 along the first direction (the X direction). For example, the second width D2 of the first portion 300_P1 along the first direction (the X direction)) may be about 0.1 µm or more and about 5 µm or less. In this range, for example, the area of the active area AA in which a current path is formed from the source electrode 173 toward the drain electrode 175 by the gate electrode 150 is sufficiently secured, and at the same time, the barrier pattern 300 may effectively alleviate the electric field generated by the portion of the gate electrode 150 positioned within the plurality of crossing regions 163. However, example embodiments are not limited thereto, the second width D2 of the first portion 300_P1 along the first direction (the X direction) may be smaller than or equal to or substantially equal to the first width D1 of the second extending pattern 152 of the gate electrode 150 along the first direction (the X direction). A description thereof will be given later in FIG. 13 below.

Additionally, the first portion 300_P1 may be positioned spaced apart from each other on the bottom surface of the gate electrode 150. For example, as illustrated in FIG. 7, the barrier pattern 300 may be positioned spaced along the second direction (the Y direction) on the bottom surface of the plurality of second extending patterns 152 that extend in the second direction (the Y direction). At this time, the active area AA may be positioned between the first portions 300_P1 spaced apart in the second direction (the Y direction). The upper surface of the first conductivity type epitaxial layer 131 positioned in the active area AA may be in contact with the gate insulating layer 140.

The second portion 300_P2 may be positioned on the first conductivity type epitaxial layer 131. The second portion 300_P2 may be positioned on the first conductivity type epitaxial layer 131 positioned in the dummy area DA. That is, the second portion 300_P2 may be positioned adjacent to a plurality of crossing regions 163.

The second portion 300_P2 may extend from one end of the barrier pattern 300 in the horizontal direction (the first direction (the X direction) and/or the second direction (the Y direction)). For example, the second portion 300_P2 may extend by the same distance in the horizontal direction (the first direction (the X direction) and/or second direction (the Y direction)) from one end of the barrier pattern 300, so that the barrier pattern 300 according to some example embodiments may have a circular shape in a plane. However, the plane shape of the second portion 300_P2 may be changed in various ways, but example embodiments are not limited thereto. A description of this will be given later with reference to FIG. 12 and FIG. 17.

The second portion 300_P2 may be positioned between the first conductivity type epitaxial layer 131 and the first conductivity type doping layer 137 and between the first conductivity type epitaxial layer 131 and the second conductivity type doping layer 135. That is, the second portion 300_P2 may be positioned on the bottom surface of the first conductivity type doping layer 137 and the bottom surface of the second conductivity type doping layer 135. The second portion 300_P2 may overlap the first conductivity type doping layer 137 and the second conductivity type doping layer 135 in the third direction (the Z direction). The upper surface of the second portion 300_P2) may be in contact with the first conductivity type doping layer 137 and the second conductivity type doping layer 135, but example embodiments are not limited thereto. Accordingly, the second portion 300_P2) may be electrically connected to the source electrode 173 through the second conductivity type doping layer 135. The second portion 300_P2 overlap the source electrode 173 in the third direction (the Z direction), but example embodiments are not limited thereto.

According to some example embodiments, the semiconductor device may cause a current to flow in the third direction (the Z direction) from the source electrode 173 positioned in the active area AA toward the drain electrode 175 when a turn-on signal is applied to the gate electrode 150. At this time, the current may flow from the source electrode 173 through the first conductivity type doping layer 137, the first conductivity type epitaxial layer 131, the first conductivity type substrate 110 to the drain electrode 175. At this time, the gate trench 160 of the semiconductor device according to some example embodiments may have a lattice pattern on a plane, and the gate electrode 150 positioned within the gate trench 160 may also have a lattice pattern on a plane. Meanwhile, when a turn-on signal is applied to the gate electrode 150, an electric field may be generated around the gate electrode 150. In particular, an electric field of a relatively high intensity may occur in the region around the plurality of crossing regions 163 of the gate trench 160.

The barrier pattern 300 of the semiconductor device according to some example embodiments may be in contact with the second conductivity type doping layer 135 and may be doped with the same conductivity type as the second conductivity type doping layer 135. Accordingly, the barrier pattern 300 may be electrically connected to the source electrode 173 through the second conductivity type doping layer 135. Additionally, the barrier pattern 300 of the semiconductor device according to some example embodiments may surround at least a portion of the gate trench 160. Particularly, since the barrier pattern 300 surrounds at least a portion of the plurality of crossing regions 163 of the gate trench 160, the barrier pattern 300 may alleviate an electric field generated by a portion of the gate electrode 150 positioned within the plurality of crossing regions 163. Accordingly, the reliability of the semiconductor device according to some example embodiments may be improved.

Furthermore, in the semiconductor device according to some example embodiments, when a turn-on signal is applied to the gate electrode 150, a current may be prevented from flowing from the source electrode 173 toward the drain electrode 175 in the dummy area DA. In other words, when a turn-on signal is applied to the gate electrode 150 portion surrounded by the barrier pattern 300, a current flow need not occur from the source electrode 173 toward the drain electrode 175. This is because the barrier pattern 300 is electrically connected to the source electrode 173 and maintained at a desired (and/or alternatively predetermined) voltage (e.g., a ground voltage, etc.), so that no current path is formed within the first conductivity type doping layer 137 and the first conductivity type epitaxial layer 131.

In a case of a comparative example where a barrier pattern 300 is positioned under a plurality of first extensions 161 and a plurality of second extensions 162, the width of the gate electrode 150 may have a range greater than or equal to or substantially equal to the width of the barrier pattern 300 to reduce and/or prevent the current path from being not formed by the barrier pattern 300 around the plurality of first extensions 161 and the plurality of second extensions 162.

The barrier pattern 300 of the semiconductor device according to some example embodiments may be positioned below the plurality of crossing regions 163 of the gate trench 160 and may not be positioned below at least a portion of the plurality of first extensions 161 and at least a portion of the plurality of second extensions 162. Accordingly, the process of forming the barrier pattern 300 under the plurality of first extensions 161 and the plurality of second extensions 162 may be omitted, and the width of the gate electrode 150 may be designed to be relatively smaller compared to the case where the barrier pattern 300 is positioned under the plurality of first extensions 161 and the plurality of second extensions 162. Accordingly, the distance between the plurality of adjacent unit cell regions 130 may be reduced, thereby improving the integrity of the semiconductor device according to some example embodiments.

The semiconductor device according to some example embodiments may be an n-type field effect transistor (n-FET). However, example embodiments are not limited thereto, and the semiconductor device according to some example embodiments may be a p-type field effect transistor (p-FET). For example, the first conductivity type substrate 110, the first conductivity type epitaxial layer 131, and the first conductivity type doping layer 137 may be doped with a p-type, and the second conductivity type doping layer 135 and the barrier pattern 300 may be doped with an n-type.

The semiconductor device according to some example embodiments is described as having the structure in which the gate electrode 150 is positioned within the gate trench 160 and the source electrode 173 is positioned in a layer higher than the gate electrode 150, but example embodiments are not limited thereto. For example, in some example embodiments, a semiconductor device may have a gate electrode 150 positioned within a gate trench 160 and a source electrode 173 positioned within a source trench positioned at one side of the gate trench 160. A wall region having a second conductivity type may be further included between the first conductivity type epitaxial layer 131 and the first conductivity type doping layer 137 and between the first conductivity type epitaxial layer 131 and the second conductivity type doping layer 135. As another example, a semiconductor device according to some example embodiments may have the gate electrode 150 positioned on the upper surface of the first conductivity type epitaxial layer 131, and the source electrode 173 positioned between the gate electrodes 150 on the first conductivity type epitaxial layer 131. A wall region having a second conductivity type may be further included between the first conductivity type epitaxial layer 131 and the first conductivity type doping layer 137 and between the first conductivity type epitaxial layer 131 and the second conductivity type doping layer 135. As another example, the semiconductor device according to some example embodiments may include a Si insulated gate bipolar transistor (IGBT) structure. As another example, the semiconductor device according to some example embodiments may include a super junction structure in which a P-type region and an N-type region are completely depleted, thereby forming a two-dimensionally uniform or substantially uniform electric field distribution. Even for these example embodiments, it is of course possible to include the barrier pattern 300 according to the example embodiments of FIG. 1 to FIG. 7.

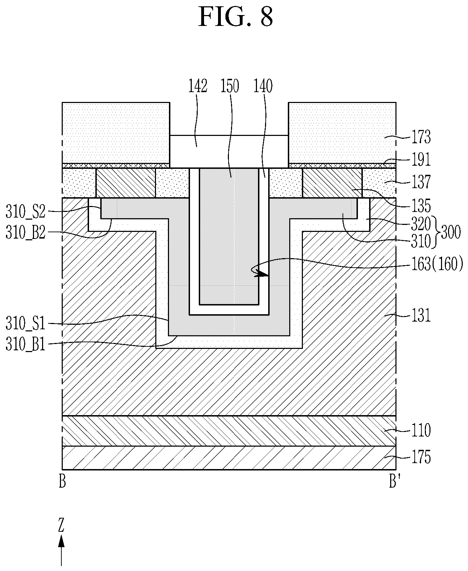

Next, semiconductor devices according to some example embodiments are described with reference to FIG. 8 to FIG. 11.

FIG. 8 to FIG. 11 are cross-sectional views showing semiconductor devices according to some example embodiments corresponding to a line B-B' of FIG. 1.

FIG. 8 to FIG. 11 illustrate numerous variations of the semiconductor devices according to the embodiments depicted in FIG. 1 to FIG. 7. The example embodiments illustrated in FIG. 8 to FIG. 11 are substantially the same as the example embodiments illustrated in FIG. 1 to FIG. 7, so a description thereof is omitted and the differences will be mainly explained. Additionally, the same reference numerals are used for the same components as in the previous example embodiments. In the example embodiments illustrated in FIG. 8 to FIG. 11, the shape of the barrier pattern 300 may be slightly different from the previous example embodiments.

Referring to FIG. 8 to FIG. 11, the barrier pattern 300 of the semiconductor device according to some example embodiments may be formed of multiple layers. For example, the barrier pattern 300 can include a first barrier pattern 310 surrounding at least a portion of the gate trench 160 and positioned on the bottom surface of the second conductivity type doping layer 135, and a second barrier pattern 320 positioned between the first barrier pattern 310 and the first conductivity type epitaxial layer 131.

The first barrier pattern 310 and the second barrier pattern 320 may be doped with the same conductivity type. For example, the first barrier pattern 310 and the second barrier pattern 320 may be doped with a p-type. The first barrier pattern 310 and the second barrier pattern 320 may be doped with different concentrations, but example embodiments are not limited thereto. However, even in this case, the doping concentration of the first barrier pattern 310 and the doping concentration of the second barrier pattern 320 may be less than or equal to or substantially equal to the doping concentration of the second conductivity type doping layer 135. Additionally, the doping concentration of the first barrier pattern 310 and the doping concentration of the second barrier pattern 320 may be greater than or equal to or substantially equal to the doping concentration of the first conductivity type epitaxial layer 131.

In some example embodiments, the second barrier pattern 320 may surround at least a portion of the first barrier pattern 310. For example, referring to FIG. 8, the second barrier pattern 320 may completely surround the first barrier pattern 310. The second barrier pattern 320 may be positioned on the first side surface 310_S1, the second side surface 310_S2, the first bottom surface 310_B1, and the second bottom surface 310_B2 of the first barrier pattern 310. Accordingly, the first barrier pattern 310 may be positioned apart from the first conductivity type epitaxial layer 131. The second barrier pattern 320 may be in contact with the second conductivity type doping layer 135, but example embodiments are not limited thereto.

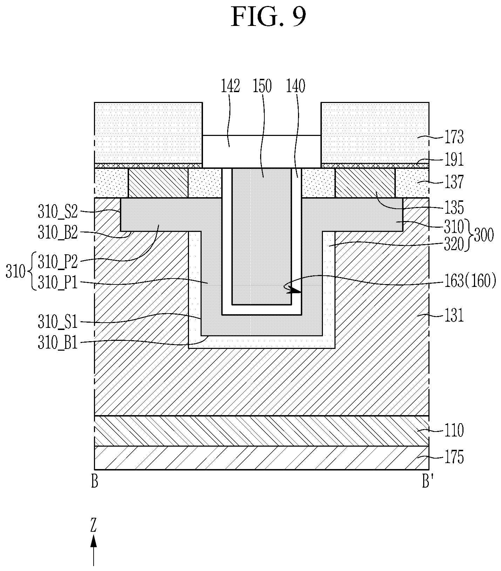

As another example, referring to FIG. 9, the second barrier pattern 320 of the semiconductor device according to some example embodiments may surround a portion of the first barrier pattern 310. For example, the second barrier pattern 320 may be positioned on the first side surface 310_S1 and the first bottom surface 310_B1 of the first barrier pattern 310, and may not be positioned on the second side surface 310_S2 and the second bottom surface 310_B2 of the first barrier pattern 310. In other words, the second barrier pattern 320 may surround the first portion 310_P1 of the first barrier pattern 310, but may not surround the second portion 310_P2 of the first barrier pattern 310. Here, the first portion 310_P1 of the first barrier pattern 310 may mean a portion of the first barrier pattern 310 that surrounds at least a part of the gate trench 160, and the second portion 310_P2 of the first barrier pattern 310 may refer to a portion of the first barrier pattern 310 that extends from one end of the first portion 300_P1 in the horizontal direction (the first direction (the X direction) and/or the second direction (the Y direction)) and overlaps the second conductivity type doping layer 135 in the third direction (the Z direction).

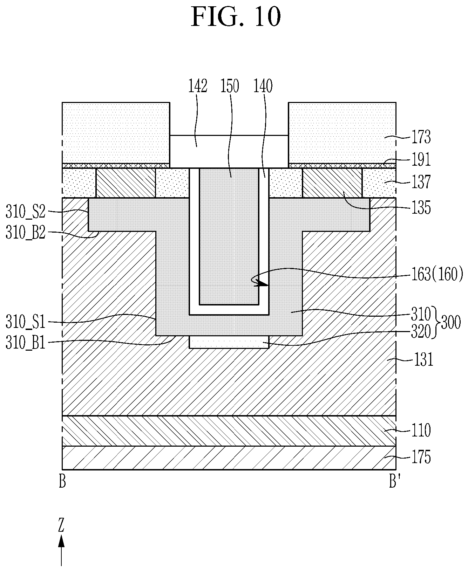

As another example, referring to FIG. 10, the second barrier pattern 320 may be positioned only on the first bottom surface 310_B1 of the first barrier pattern 310. That is, the second barrier pattern 320 need not be positioned on the second bottom surface 310_B2, the first side surface 310_S1, and the second side surface 310_S2 of the first barrier pattern 310. The second barrier pattern 320 may be positioned on at least a portion of the first bottom surface 310_B1 of the first barrier pattern 310, but example embodiments are not limited thereto. For example, the second barrier pattern 320 may be positioned entirely on the first bottom surface 310_B1 of the first barrier pattern 310.

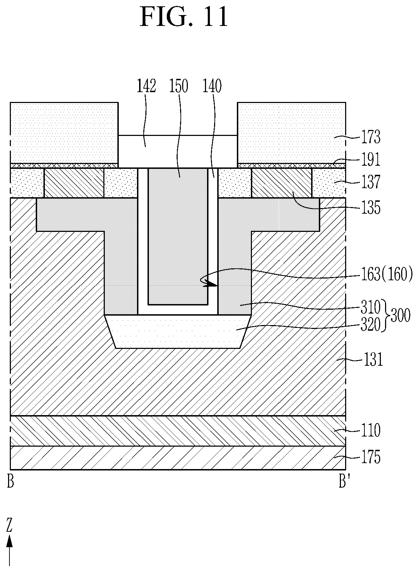

Referring to FIG. 11, the first barrier pattern 310 of the semiconductor device according to some example embodiments may be positioned above the sidewall of the gate trench 160 and may not be positioned below the gate trench 160. The first barrier pattern 310 may be positioned on the sidewall of the gate trench 160, and the second barrier pattern 320 may be positioned below the gate trench 160. That is, the first barrier pattern 310 may define the sidewall of the gate trench 160, and the second barrier pattern 320 may define the bottom surface of the gate trench 160. The gate trench 160 may be surrounded by the first barrier pattern 310 and the second barrier pattern 320.

Hereinafter, a semiconductor device according to some example embodiments will be described with reference to FIG. 12 to FIG. 17.

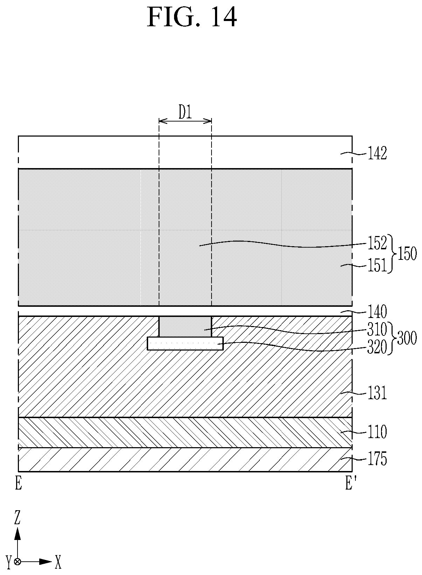

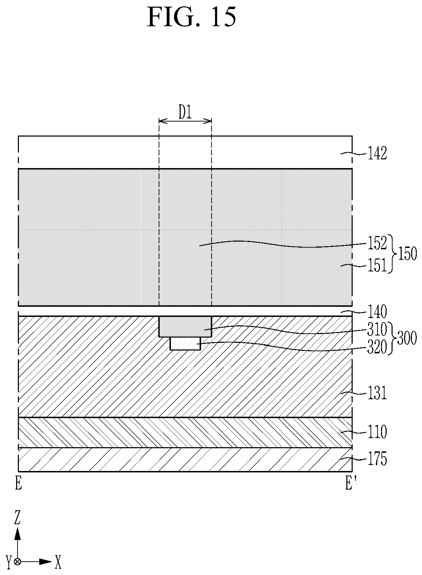

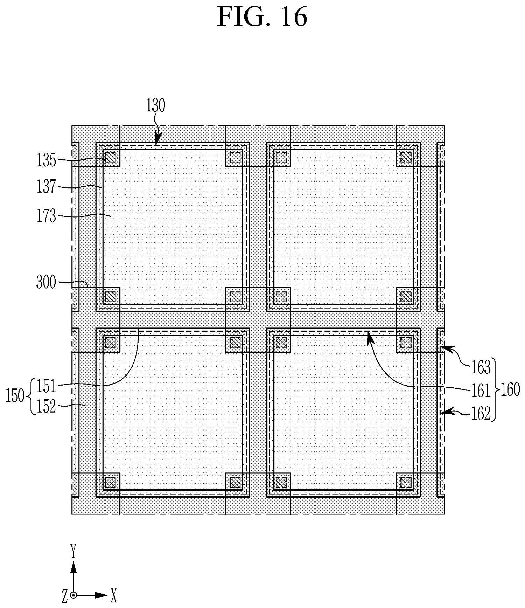

FIG. 12 is a top plan view showing a semiconductor device according to some example embodiments. FIG. 13 is a cross-sectional view taken along a line E-E' of FIG. 12. FIG. 14 and FIG. 15 are cross-sectional views corresponding to a line E-E' of FIG. 12, illustrating semiconductor devices according to some example embodiments. FIG. 16 and FIG. 17 are top plan views illustrating semiconductor devices according to some example embodiments.

FIG. 12 to FIG. 17 illustrate numerous variations of the semiconductor device according to the example embodiments depicted in FIG. 1 to FIG. 7. The example embodiments illustrated in FIG. 12 to FIG. 17 are mainly the same as the example embodiments illustrated in FIG. 1 to FIG. 7, so a description thereof will be omitted and the differences will be mainly explained. Additionally, the same reference numerals are used for the same components as in the previous example embodiments.

The barrier pattern 300 of the semiconductor device according to some example embodiments may have various planar shapes.

Referring to FIG. 12, for example, the barrier pattern 300 may include a third portion 300_P3 that overlaps the second conductivity type doping layer 135 in the third direction (the Z direction), a fourth portion 300_P4 that overlaps the plurality of crossing regions 163 of the gate trench 160 in the third direction (the Z direction), and a fifth portion 300_P5 that is positioned between the third portion 300_P3 and the fourth portion 300_P4.

The planar shape of the third portion 300_P3 may be substantially the same as the planar shape of the second conductivity type doping layer 135, but example embodiments are not limited thereto. For example, the second conductivity type doping layer 135 and the third portion 300_P3 may have an approximately square shape, but example embodiments are not limited thereto. The fifth portion 300_P5 may extend in a first diagonal direction DR1 intersecting the first direction (the X direction) and the second direction (the Y direction) or a second diagonal direction DR2 intersecting in the first direction (the X direction), the second direction (the Y direction), and the first diagonal direction DR1. The fifth portion 300_P5 may be extended in the first diagonal direction DR1 and the second diagonal direction DR2 to connect the third portion 300_P3 and the fourth portion 300_P4.

Referring further to FIG. 13, the third width D3 of the fifth portion 300_P5 along the first direction (the X direction) may be substantially the same as the first width D1 of the plurality of second extensions 162 of the gate electrode 150 along the first direction (the X direction). In other words, the width of the portion of the barrier pattern 300 that overlaps the gate electrode 150 in the third direction (the Z direction) along the first direction (the X direction) may be substantially the same as the first width D1 of the plurality of second extensions 162 along the first direction (the X direction). However, example embodiments are not limited thereto, as another example, the third width D3 of the fifth portion 300_P5 along the first direction (the X direction) may be larger or smaller than the first width D1 of the plurality of second extensions 162 of the gate electrode 150 along the first direction (the X direction).

Alternatively, referring further to FIG. 14, the barrier pattern 300 of the semiconductor device according to some example embodiments may be formed of multiple layers. For example, the barrier pattern 300 may include a first barrier pattern 310 positioned over the first conductivity type epitaxial layer 131 and a second barrier pattern 320 positioned between the first barrier pattern 310 and the first conductivity type epitaxial layer 131. At this time, the width of the second barrier pattern 320 portion that overlaps the gate electrode 150 in the third direction (the Z direction) along the first direction (X direction) may be larger than the width of the first barrier pattern 310 portion that overlaps the gate electrode 150 in the third direction (the Z direction) along the first direction (the X direction). That is, the width of the second barrier pattern 320 portion that overlaps the gate electrode 150 in the third direction (the Z direction) along the first direction (the X direction) may be larger than the first width D1 of the plurality of second extensions 162 of the gate electrode 150 along the first direction (the X direction).

As another example, referring further to FIG. 15, the width of the portion of the second barrier pattern 320 that overlaps the gate electrode 150 in the third direction (the Z direction) along the first direction (the X direction) may be smaller than the width of the portion of the first barrier pattern 310 that overlaps the gate electrode 150 in the third direction (the Z direction) along the first direction (the X direction). That is, the width of the second barrier pattern 320 portion that overlaps the gate electrode 150 in the third direction (the Z direction) along the first direction (the X direction) may be smaller than the first width D1 of the plurality of second extensions 162 of the gate electrode 150 along the first direction (the X direction). However, example embodiments are not limited thereto, the width of the second barrier pattern 320 portion that overlaps the gate electrode 150 in the third direction (the Z direction) along the first direction (the X direction)may be substantially the same as the width of the first barrier pattern 310 portion that overlaps the gate electrode 150 in the third direction (the Z direction) along the first direction (the X direction).

Referring to FIG. 16 and FIG. 17, in a plane consisting of the first direction (the X direction) and the second direction (the Y direction), the barrier pattern 300 of the semiconductor device according to some example embodiments may have a polygonal shape. For example, as illustrated in FIG. 16, on a plane consisting of the first direction (the X direction) and the second direction (the Y direction), the barrier pattern 300 may have an approximately rectangular shape. As another example, as illustrated in FIG. 17, on a plane consisting of the first direction (the X direction) and the second direction (the Y direction), the barrier pattern 300 may have an approximately hexagon shape. However, the plane shape of the barrier pattern 300 may be changed in various ways, but example embodiments are not limited thereto.

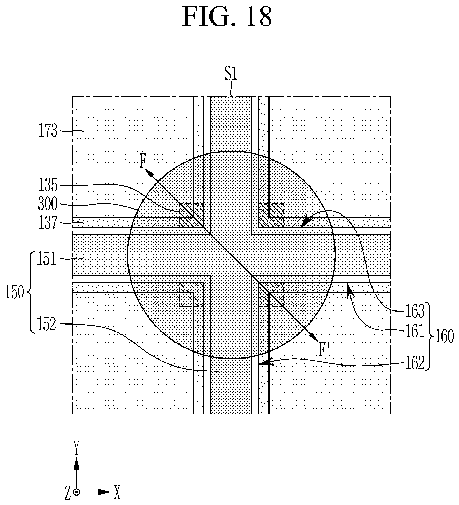

Hereinafter, semiconductor devices according to some example embodiments will be described with reference to FIG. 18 to FIG. 21.

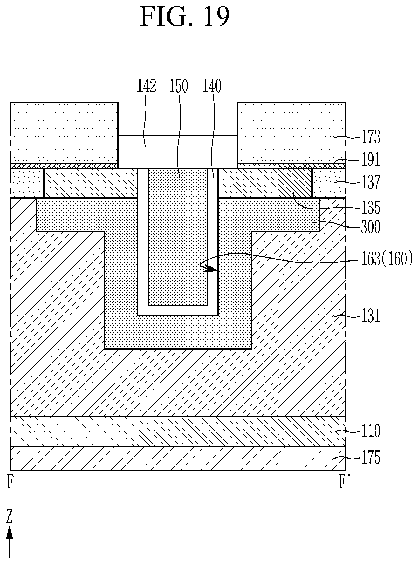

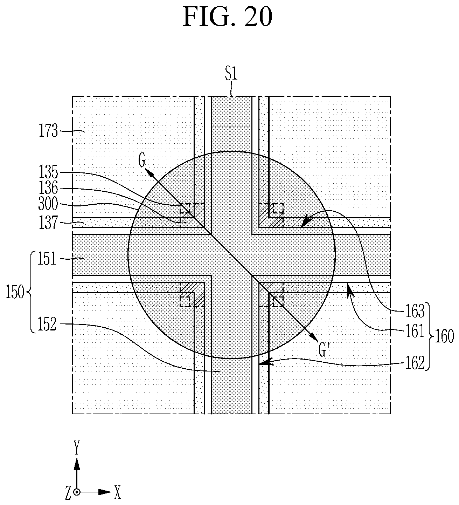

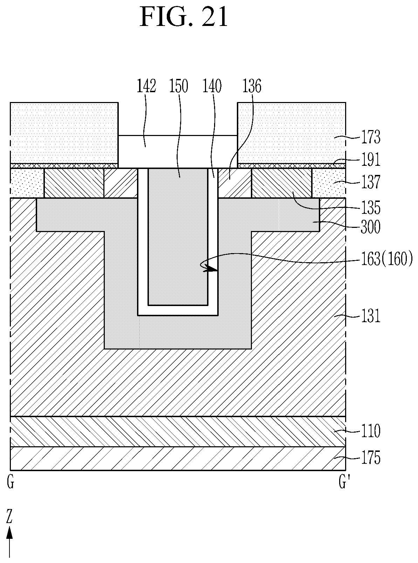

FIG. 18 is a top plan view corresponding to a region S1 of FIG. 1, showing a semiconductor device according to some example embodiments. FIG. 19 is a cross-sectional view taken along a line F-F' of FIG. 18. FIG. 20 is a top plan view corresponding to a region S1 of FIG. 1, showing a semiconductor device according to some example embodiments. FIG. 21 is a cross-sectional view taken along a line F-F' of FIG. 20.

FIG. 18 to FIG. 21 illustrate numerous variations of the semiconductor devices according to the example embodiments depicted in FIG. 1 to FIG. 7. The example embodiments illustrated in FIG. 18 to FIG. 21 are mainly the same as the example embodiments illustrated in FIG. 1 to FIG. 7, so a description thereof will be omitted and the differences will be mainly explained. Additionally, the same reference numerals are used for the same components as in the previous example embodiments.

Referring to FIG. 18 and FIG. 19, the second conductivity type doping layer 135 of the semiconductor device according to some example embodiments may have various planar shapes. The second conductivity type doping layer 135 may not be surrounded by the first conductivity type doping layer 137. For example, the second conductivity type doping layer 135 may be positioned at the corner end of the first conductivity type doping layer 137. At least a portion of the second conductivity type doping layer 135 may overlap the source electrode 173 in the third direction (the Z direction), and the remaining portion may not overlap the source electrode 173 in the third direction (the Z direction). At this time, the remaining part of the second conductivity type doping layer 135 may overlap the capping layer 142 in the third direction (the Z direction). Accordingly, the second conductivity type doping layer 135 may form a part of the sidewall of the gate trench 160. The side of the second conductivity type doping layer 135 may be in contact with the gate insulating layer 140, but example embodiments are not limited thereto.

Referring to FIG. 20 and FIG. 21, a dummy layer 136 may be positioned on a first conductivity type epitaxial layer 131 of a semiconductor device according to some example embodiments. The dummy layer 136 may overlap the barrier pattern 300 in the third direction (the Z direction). The dummy layer 136 may form a part of the sidewall of the gate trench 160. One side of the dummy layer 136 may be in contact with the second conductivity type doping layer 135 and the other side may be in contact with the gate insulating layer 140, but example embodiments are not limited thereto. In some example embodiments, the dummy layer 136 may be an undoped layer, but example embodiments are not limited thereto. As another example, the dummy layer 136 may be doped with the same conductivity type as the first conductivity type doping layer 137, the second conductivity type doping layer 135, or the first conductivity type epitaxial layer 131, or the dummy layer 136 may be doped with a different concentration than the first conductivity type doping layer 137, the second conductivity type doping layer 135, or the first conductivity type epitaxial layer 131.

While this disclosure has been described in connection with what is presently considered to be practical example embodiments, it is to be understood that the disclosure is not limited to the disclosed example embodiments, but, on the contrary, is intended to cover various modifications and equivalent arrangements included within the scope of the appended claims.

## Claims

1. A semiconductor device comprising:
a first conductivity type substrate;
a first conductivity type epitaxial layer on a first surface of the first conductivity type substrate, and the first conductivity type epitaxial layer including a gate trench;
a gate electrode in the gate trench;
a gate insulating layer between the first conductivity type epitaxial layer and the gate electrode;
a source electrode above the first conductivity type epitaxial layer;
a first conductivity type doping layer between the first conductivity type epitaxial layer and the source electrode, and the first conductivity type doping layer having a first conductivity type;
a second conductivity type doping layer having a second conductivity type, the second conductivity type different from the first conductivity type;
a drain electrode on a second surface of the first conductivity type substrate; and
a barrier pattern including
a first portion surrounding at least a portion of the gate trench, and
a second portion between the first conductivity type epitaxial layer and the second conductivity type doping layer.

2. The semiconductor device of claim 1, wherein the barrier pattern contacts a bottom surface of the second conductivity type doping layer.

3. The semiconductor device of claim 1 or 2, wherein the barrier pattern has the second conductivity type.

4. The semiconductor device of claim 1, 2, or 3, wherein the first conductivity type is an n-type, and the second conductivity type is a p-type.

5. The semiconductor device of any one of claims 1 to 4, wherein
the first portion is below the gate trench and surrounds at least a portion of a sidewall of the gate trench, and
the second portion is on a bottom surface of the first conductivity type doping layer and a bottom surface of the second conductivity type doping layer.

6. The semiconductor device of claim 5, wherein the first portion contacts the gate insulating layer, and the second portion contacts the bottom surface of the second conductivity type doping layer.

7. The semiconductor device of any one of claims 1 to 6, wherein
the gate trench includes
a plurality of first extensions extending in a first direction,
a plurality of second extensions extending in a second direction, the second direction intersecting the first direction, and
a plurality of crossing regions where the plurality of first extensions and the plurality of second extensions intersect each other, and
the barrier pattern surrounds at least part of each of the plurality of crossing regions.

8. The semiconductor device of claim 7, wherein the barrier pattern includes a plurality of barrier patterns, and each of the plurality of barrier patterns is spaced apart from each other in the first direction and the second direction.

9. The semiconductor device of claim 8, wherein the plurality of first extensions and the plurality of second extensions do not overlap the barrier pattern.

10. The semiconductor device of claim 7, wherein the barrier pattern is a circular shape on a plane.

11. The semiconductor device of any one of claims 1 to 10, wherein the second conductivity type doping layer is on a corner of the first conductivity type doping layer.

12. The semiconductor device of claim 11, wherein the first conductivity type doping layer includes a portion between the gate trench and the second conductivity type doping layer.

13. The semiconductor device of any one of claims 1 to 12, wherein the second conductivity type doping layer is surrounded by the first conductivity type doping layer in a horizontal direction.

14. The semiconductor device of any one of claims 1 to 13, wherein
the barrier pattern includes
a first barrier pattern of the second conductivity type, and the first barrier pattern surrounding at least a portion of the gate trench, and
a second barrier pattern having a same conductivity type as the second conductivity type, and the second barrier pattern surrounding at least a portion of the first barrier pattern, and
a doping concentration of the first barrier pattern is different from a doping concentration of the second barrier pattern.

15. The semiconductor device of any one of claims 1 to 14, wherein the plurality of crossing regions are arranged spaced apart in the first direction and the second direction.
